# EUROPÄISCHE PATENTSCHRIFT

(11) **EP 3 317 916 B1**
(45) Veröffentlichungstag und Bekanntmachung des Hinweises auf die Patenterteilung: **13.05.2020**
(21) Anmeldenummer: 16740972.1
(22) Anmeldetag: 30.06.2016
(51) Int. Cl.: H01P 5/18

(54) **RICHTKOPPLER**
DIRECTIONAL COUPLER
COUPLEUR DIRECTIF

(30) Priorität: 30.06.2015 DE 102015212184
(43) Veröffentlichungstag der Anmeldung: 09.05.2018
(73) Patentinhaber: TRUMPF Hüttinger GmbH + Co. KG, 79111 Freiburg (DE)
(72) Erfinder: GREDE, André, 3018 Bern (CH); ALT, Alexander, Cardiff CF143UA (GB); GRUNER, Daniel, 79379 Muellheim (DE); SCHWERG, Nikolai, 1202 Genève (CH); WANGLER, Christian, 79232 March (DE)
(74) Vertreter: Trumpf Patentabteilung
(86) Internationale Anmeldenummer: PCT/EP2016/065378
(87) Internationale Veröffentlichungsnummer: WO 2017/001596

(56) Entgegenhaltungen:
- US-A- 5 907 266
- US-A- 6 104 240
- US-A1- 2005 146 394
- US-A1- 2008 036 554
- US-A1- 2010 026 415
- US-A1- 2011 148 544

## Beschreibung

Die Erfindung betrifft einen Richtkoppler, der zumindest teilweise in einer insbesondere mehrlagigen Leiterkarte ausgebildet ist.

Außerdem betrifft die Erfindung ein Verfahren zum Abstimmen eines Richtkopplers.

Ein Richtkoppler ist beispielweise aus US2005/0017821 A1 bekannt.

Hochfrequenzgeneratoren werden dafür eingesetzt, eine Hochfrequenzleistung zu erzeugen und an eine Last zu liefern. Als Last kommen beispielsweise Plasmaprozesse, wie Plasmabeschichten und Plasmaätzen, oder Laserprozesse (Laseranregung) in Frage. Da sich die Impedanz der Last ändern kann und es somit bei Fehlanpassung zur (teilweisen) Reflektion der von dem Hochfrequenzgenerator gelieferten Leistung kommen kann, wird häufig nicht die gesamte von dem Hochfrequenzgenerator gelieferte Leistung in der Last (dem Plasma) absorbiert. Um die in die Last gelieferte Hochfrequenzleistung genau einstellen bzw. regeln zu können, ist es wünschenswert, die in der Last absorbierte Leistung zu bestimmen.

Es ist bekannt, zur Messung/Bestimmung der in einer Last absorbierten Hochfrequenzleistung einen Richtkoppler einzusetzen, wobei die absorbierte Hochfrequenzleistung sich aus der Differenz der von dem Hochfrequenzgenerator erzeugten Leistung und der reflektierten Leistung ergibt. Dadurch ist es möglich, den Hochfrequenzgenerator so zu regeln, dass die in der Last absorbierte Leistung hoch genau eingestellt und konstant gehalten werden kann.

Um sowohl die in Richtung Last gelieferte Hochfrequenzleistung als auch die reflektierte Leistung erfassen zu können, ist es bekannt, Richtkoppler einzusetzen, die neben einer Hauptleitung, über die die Hochfrequenzleistung in Richtung Last gesendet wird, zwei Nebenleitungen aufweisen. Über eine Nebenleitung kann dabei die in Richtung Last gelieferte Leistung gemessen werden und über die andere Nebenleitung kann die reflektierte Leistung gemessen werden. Aufgrund der Lieferung der Hochfrequenzleistung über die Hauptleitung entstehen elektromagnetische Felder, die auf die Nebenleitungen gekoppelt werden, so dass an den Nebenleitungen ein Messsignal erfasst werden kann, welches mit der Leistung auf der Hauptleitung in Beziehung steht.

Mit dem Begriff Richtschärfe (directivity) wird die Qualität der Messung beschrieben. Ziel ist es, auf der einen Nebenleitung möglichst nur Anteile der in Richtung Last gelieferten Leistung zu detektieren und mit der anderen Nebenleitung möglichst nur Anteile der reflektierten Leistung zu detektieren. In der Praxis wird dies jedoch nicht vollständig erreicht. Das bedeutet, dass mit der einen Nebenleitung, mit der nur die in Richtung Last gelieferte Leistung detektiert werden soll, auch immer ein kleiner Anteil der reflektierten Leistung detektiert wird. Mit der Richtschärfe wird das Verhältnis von der Leistungsdetektion des gewünschten Signals zu der Leistungsdetektion des unerwünschten Signals bezeichnet. Die Richtschärfe sollte möglichst groß sein.

Häufig werden Richtkoppler auf Leiterkarten realisiert. Solche Richtkoppler unterliegen jedoch Fertigungsschwankungen, deren Auswirkungen sich erst nach der Herstellung mit der Überprüfung der Funktion zeigen. Liegt bei mehrlagigen Leiterkartenrichtkopplern die Koppelstruktur auf einer Innenlage, kann die Geometrie der Kopplerstruktur im Nachhinein nicht mehr, z.B. durch Lasertrimmen, angepasst werden. Die Toleranzen müssen somit hingenommen werden, was zu einer geringeren Dynamik einer Messung führt.

In US 2005/0146394 A1 ist ein Koppler mit zwei planaren Koppelleitungen offenbart, die teilweise in einer und teilweise in unterschiedlichen Ebenen übereinander verlaufen, so dass die Kopplung teilweise flächig und teilweise seitlich erfolgt.

In US 2011/0148544 A1 ist ein Richtkoppler mit einer Hauptleitung offenbart, die in einem dielektrischen Substrat eingebettet ist, sowie mit zwei Nebenleitungen, die ebenfalls in dem dielektrischen Substrat eingebettet sind.

In US 2008/0036554 A1 ist ein Richtkoppler mit einer planar ausgebildeten Hauptleitung auf der Oberseite einer gedruckten Leiterkarte offenbart und zwei Nebenleitungen, die im Innern der Leiterkarte auf unterschiedlichen Ebenen angeordnet sind.

In US 6,104,240 ist eine Mikrowellenschaltung mit einem Koppler offenbart. Der Koppler weist zwei verkoppelte Mikrostrip-Leitungen auf der vorderen Oberfläche eines Substrats auf. Auf der Rückseite des Substrats befindet sich eine Massefläche. Zwischen den Mikrostrip-Leitungen ist zumindest ein elektrischer Leiter vorgesehen, der über einen Schalter mit Masse verbunden werden kann, um den Koppel-Koeffizienten zu verändern.

In US 2010/0026415 A1 ist ein Richtkoppler offenbart, mit mathematisch vorgegebenen Zusammenhängen für die einzustellenden Werte der Kopplung und Isolation jeweils in Vorwärts- und in Rückwärtsrichtung.

Aufgabe der vorliegenden Erfindung ist es, einen Richtkoppler derart weiterzubilden, dass Auswirkungen von Fertigungstoleranzen entgegengewirkt werden kann bzw. diese ausgeglichen werden können.

Gelöst wird diese Aufgabe erfindungsgemäß durch einen Richtkoppler nach Anspruch 1. Ein solcher Richtkoppler ist zumindest teilweise in einer insbesondere mehrlagigen Leiterkarte ausgebildet, mit einer Hauptleitung zur Übertragung einer Leistung und zwei Nebenleitungen, die in einem Kopplungsbereich mit einem Kopplungsabschnitt parallel und beabstandet zur Hauptleitung angeordnet sind, wobei im Kopplungsbereich die Hauptleitung und die zwei Nebenleitungen im Inneren der Leiterkarte angeordnet sind, wobei an den Nebenleitungen m erste Zusatzkoppelleitungen, m ≥ 1, vorgesehen sind, die jeweils einen Kopplungsabschnitt aufweisen, der parallel und beabstandet zum Kopplungsabschnitt der jeweiligen Nebenleitung verläuft, wobei die ersten Zusatzkoppelleitungen einen Anschluss aufweisen, der an der Außenseite der Leiterkarte angeordnet ist zur Verbindung mit Masse oder einer externen Beschaltung, so dass durch die Verbindung eines oder mehrerer der Anschlüsse der Zusatzkoppelleitungen mit Masse die Kopplung des Richtkopplers eingestellt werden kann bzw. Fertigungstoleranzen korrigiert werden können. Vorzugsweise werden die ersten Zusatzkoppelleitungen mit Masse verbunden. So kann die Kopplung verringert werden. Insbesondere können auf diese Art und Weise beispielsweise positive Dickentoleranzen des Leiterkartenmaterials ausgeglichen werden. Durch die Zusatzkoppelleitungen können sowohl die Kopplung als auch die Entkopplung beeinflusst werden. Dadurch kann der erforderliche Einstellbereich von nachfolgenden Sumpfbeschaltungen zur Maximierung der Isolation des Richtkopplers reduziert werden. Die Nachteile des Standes der Technik, die zu einer geringeren Messdynamik führen, können vermieden werden. Insbesondere kann durch die erfindungsgemäße Maßnahme die Messdynamik des gesamten Messsystems verbessert werden. Beim Richtkoppler wird die toleranzbedingte Streuung verbessert.

Insbesondere kann durch geeignete Zusatzkoppelleitungen das Messsignal entweder abgeschwächt oder verstärkt werden, um die Auswirkungen von Fertigungstoleranzen auszugleichen.

Der Kopplungsabschnitt der ersten Zusatzkoppelleitungen kann kürzer sein als der Kopplungsabschnitt zumindest einer der Nebenleitungen. Insbesondere können in Längsrichtung des Kopplungsabschnitts zumindest einer der Nebenleitungen mehrere Kopplungsabschnitte der ersten Zusatzkoppelleitungen vorgesehen sein. Beispielsweise können zwei erste Zusatzkoppelleitungen vorgesehen sein, wobei die Länge der Kopplungsabschnitte der ersten Zusatzkoppelleitungen in etwa der Hälfte der Länge des Kopplungsabschnitts zumindest einer der Nebenleitung entspricht.

Die Kopplungsabschnitte der ersten Zusatzkoppelleitungen können einen Abstand < 2 mm, insbesondere einen Abstand < 1 mm, zum Kopplungsabschnitt zumindest einer der Nebenleitungen aufweisen. Durch den geringen Abstand zum Kopplungsabschnitt zumindest einer der Nebenleitungen kann sichergestellt werden, dass die Kopplungsabschnitte der Zusatzkoppelleitungen auch wirksam werden.

Die Kopplungsabschnitte der ersten Zusatzkoppelleitungen können auf einer der Hauptleitung abgewandten Seite des Kopplungsabschnitts zumindest einer der Nebenleitungen angeordnet sein. Somit beeinflussen sie kontrolliert die Wechselwirkung zwischen der Hauptleitung und dieser Nebenleitung.

Die Kopplungsabschnitte der ersten Zusatzkoppelleitung können einen geringeren Abstand zum Kopplungsabschnitt zumindest einer der Nebenleitungen aufweisen als der Kopplungsabschnitt dieser Nebenleitung zur Hauptleitung. Auf diese Art und Weise kann eine besonders gute Feinabstimmung des Richtkopplers erfolgen.

Es können n zweite Zusatzkoppelleitungen, n ≥ 1 vorgesehen sein, die einen Kopplungsabschnitt aufweisen, der parallel und beabstandet zur Hauptleitung verläuft und die elektrisch parallel zu zumindest einer der Nebenleitungen schaltbar oder geschaltet sind. Dadurch kann die Kopplung erhöht werden. Eine zu geringe Kopplung, z.B. durch negative Dickentoleranzen des Leiterkartenmaterial, können dadurch ausgeglichen werden.

Durch geeignete Wahl der Anzahl n und m und der Verschaltung der Zusatzkoppelleitungen kann die Kopplung so fein eingestellt werden, dass die Änderung der Kopplung aufgrund von Fertigungstoleranzen minimal wird.

Die Kopplungsabschnitte der zweiten Zusatzkoppelleitungen können außerhalb des Kopplungsbereichs angeordnet sein. Insbesondere können die Kopplungsabschnitte der zweiten Zusatzkoppelleitungen in Längsrichtung des Kopplungsabschnitts zumindest einer der Nebenleitungen gesehen vor und/oder hinter dem Kopplungsabschnitt dieser Nebenleitung angeordnet sein.

Um sicher zu stellen, dass das interessierende Signal hauptsächlich durch zumindest eine der Nebenleitungen ausgekoppelt wird, kann vorgesehen sein, dass die Kopplungsabschnitte der zweiten Zusatzkoppelleitungen kürzer sind als der Kopplungsabschnitt der Nebenleitung.

Die Kopplungsabschnitte der ersten Zusatzkoppelleitungen können in derselben Lage angeordnet sein. Auch die Kopplungsabschnitte der zweiten Zusatzkoppelleitungen können in derselben Lage angeordnet sein. Insbesondere können die Kopplungsabschnitte der ersten und zweiten Zusatzkoppelleitungen in derselben oder unterschiedlichen Lagen angeordnet sein.

Weiterhin kann vorgesehen sein, dass die Kopplungsabschnitte aller Leitungen in derselben Lage angeordnet sind. Ein derart ausgestalteter Richtkoppler kann besonders einfach hergestellt werden, da sämtliche Leitungen bzw. deren Kopplungsabschnitte in einem bzw. demselben Bearbeitungsschritt der Leiterkarte hergestellt werden können.

Zumindest eine der Nebenleitungen und die Zusatzkoppelleitungen können als Leiterbahnen ausgebildet sein, wobei die Kopplungsabschnitte der Zusatzkoppelleitungen schmaler sind als der Kopplungsabschnitt dieser Nebenleitung. Durch geeignete Wahl der Breiten der Kopplungsabschnitte können die Eigenschaften des Richtkopplers beeinflusst werden.

Die Kopplungsabschnitte der Zusatzkoppelleitungen können in einer anderen Lage angeordnet sein als der Kopplungsabschnitt zumindest einer der Nebenleitungen. Dadurch entstehen weitere Einstellmöglichkeiten.

Der Richtkoppler kann bezüglich einer Mittenebene der Hauptleitung symmetrisch aufgebaut sein. Insbesondere können auf beiden Seiten der Hauptleitung Nebenleitungen und jeweils zugeordnete Zusatzkoppelleitungen vorgesehen sein.

In den Rahmen der Erfindung fällt außerdem ein Verfahren nach Anspruch 15. Dabei werden zum Abstimmen eines erfindungsgemäßen Richtkopplers eine oder mehrere Anschlüsse der ersten Zusatzkoppelleitungen mit Masse verbunden und/oder ein oder mehrere Anschlüsse der zweiten Zusatzkoppelleitungen elektrisch parallel zu zumindest einer der Nebenleitungen geschaltet, wobei der oder die mehreren Anschlüsse der ersten und/oder zweiten Zusatzkoppelleitungen zur Einstellung der Kopplung geeignet gewählt werden, so dass die Änderung der Kopplung aufgrund von Fertigungstoleranzen ausgeglichen wird.

Weitere Merkmale und Vorteile der Erfindung ergeben sich aus der nachfolgenden detaillierten Beschreibung von Ausführungsbeispielen der Erfindung, anhand der Figuren der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

In der schematischen Zeichnung sind Ausführungsbeispiele der Erfindung dargestellt und in der nachfolgenden Beschreibung näher erläutert.

Es zeigen:
- Fig. 1: eine Draufsicht auf eine Lage eines Richtkopplers;
- Fig. 2: eine Schnittdarstellung durch einen Richtkoppler.

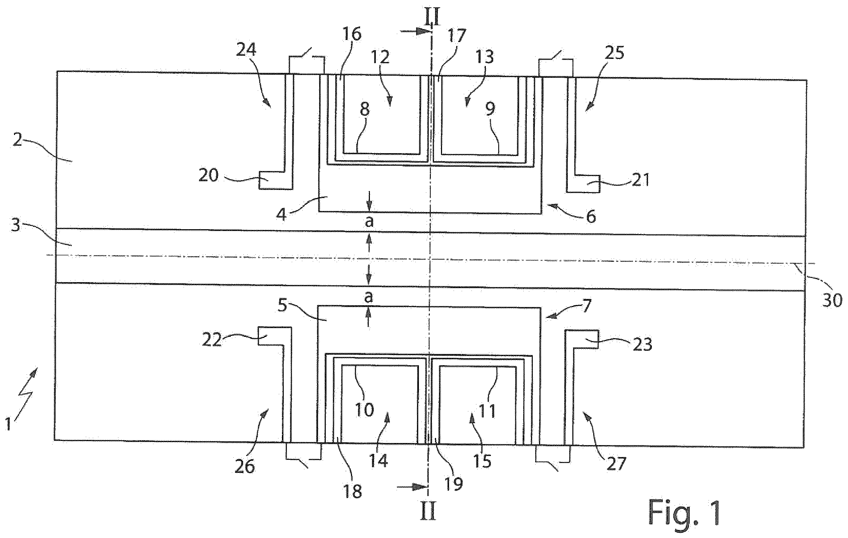

Die Figur 1 zeigt eine Draufsicht auf eine Lage eines Richtkopplers 1. Der Richtkoppler besteht aus einem mehrlagigen Leiterkartenmaterial 2, wobei im Innern des Richtkopplers 1 eine Hauptleitung 3 angeordnet ist. Die Hauptleitung 3 dient der Übertragung von Leistung, beispielsweise im gezeigten Ausführungsbeispiel von links nach rechts von einem Hochfrequenzleistungsgenerator zu einer Last bzw. von rechts nach links, wenn die Leistung einer Last reflektiert wird. Parallel zu der Hauptleitung 3 verlaufen Kopplungsabschnitte 4, 5 von Nebenleitungen 6, 7. Die Kopplungsabschnitte 4, 5 weisen einen Abstand a von der Hauptleitung 3 auf. Die Länge der Kopplungsabschnitte 4, 5 definiert einen Kopplungsbereich. Bei einem fertig hergestellten Richtkoppler 1 sind die Hauptleitung 3 und die Nebenleitungen 6, 7 von weiterem Leiterkartenmaterial abgedeckt, so dass sie sich im Innern des Richtkopplers 1 befinden. Die Koppelstruktur, umfassend die Hauptleitung 3 und die Nebenleitungen 6, 7, ist somit von außen nicht mehr zugänglich. Zwischen der Hauptleitung 3 und den Kopplungsabschnitten 4, 5 der Nebenleitungen 6, 7 kann ein anderes Material, beispielsweise Prepreg, als das übrige Leiterkartenmaterial, beispielsweise Arlon TC350 oder Rogers RO4350B vorgesehen sein.

In einem geringen Abstand und parallel zu den Kopplungsabschnitten 4, 5 der Nebenleitungen 6, 7 verlaufen Kopplungsabschnitte 8 bis 11 von ersten Zusatzkoppelleitungen 12 bis 15. Die Kopplungsabschnitte 8 bis 11 sind auf der der Hauptleitung 3 abgewandten Seite der Kopplungsabschnitte 4, 5 angeordnet. Die ersten Zusatzkoppelleitungen 12 bis 15 weisen Anschlüsse 16 bis 19 an der Außenseite der Leiterkarte 2 auf, die zur Verbindung mit Masse oder einer externen Beschaltung vorgesehen sind. Durch die Verbindung eines oder mehrerer der Anschlüsse 16 bis 19 mit Masse kann die Kopplung des Richtkopplers 1 eingestellt bzw. Fertigungstoleranzen korrigiert werden. Die Länge der Kopplungsabschnitt 8 bis 11 entspricht etwa der Hälfte der Länge der Kopplungsabschnitte 4, 5.

Weiterhin zeigt die Figur 1 Kopplungsabschnitte 20 bis 23 von zweiten Zusatzkoppelleitungen 24 bis 27, die elektrisch parallel zu den Nebenleitungen 4, 5 geschaltet werden können, was durch die eingezeichneten Schalter angedeutet ist. Dabei sind die Kopplungsabschnitte 20 bis 23 von der Hauptleitung 3 beabstandet angeordnet. Sie sind insbesondere weiter von der Hauptleitung 3 beabstandet angeordnet als die Kopplungsabschnitte 4, 5. Zu erkennen ist auch, dass die Kopplungsabschnitte 20 bis 23 außerhalb des durch die Länge der Kopplungsabschnitte 4, 5 definierten Kopplungsbereich liegen. Insbesondere sind sie in Erstreckungsrichtung der Kopplungsabschnitte 4, 5 gesehen vor und hinter den Kopplungsabschnitten 4, 5 angeordnet.

Sämtliche Kopplungsabschnitte der Zusatzkoppelleitungen weisen eine geringere Breite auf als die Kopplungsabschnitte 4, 5 der Nebenleitungen 6, 7. Sämtliche Kopplungsabschnitte sind schmaler ausgebildet als die Hauptleitung 3. Zu sehen ist auch, dass der Richtkoppler 1 bezüglich einer Mittenebene 30 symmetrisch ausgebildet ist.

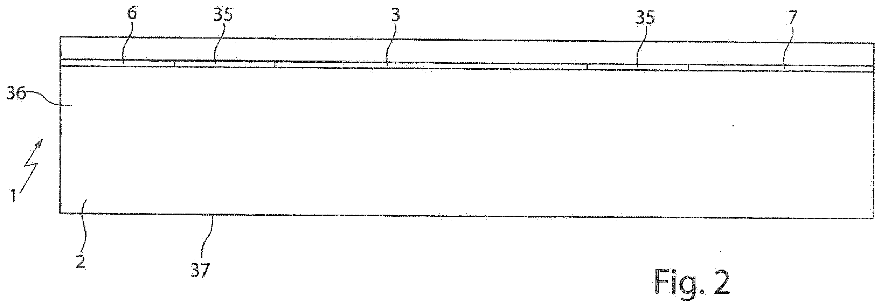

Die Figur 2 zeigt eine Schnittdarstellung durch den Richtkoppler 1 entlang der Linie II-II der Fig. 1, wobei hier keine Zusatzkoppelleitungen zu sehen sind. Neben der Hauptleitung 3 sind die Nebenleitungen 6, 7 angeordnet. Zwischen der Hauptleitung 3 und den Nebenleitungen 6, 7 befindet sind ein Material 35, welches sich vom Material 36 der übrigen Leiterkarte 2 unterscheidet, insbesondere ist das Material 35 Prepreg. Durch geeignete Wahl des Materials 35 kann auch die Kopplung des Richtkopplers 1 beeinflusst werden.

Der Figur 2 lässt sich auch entnehmen, dass die gesamte Kopplerstruktur im Inneren des Richtkopplers 1 bzw. der Leiterkarte 2 angeordnet ist und somit von außen nach der Herstellung des Richtkopplers nicht mehr zugänglich ist. An der Unterseite weist die Leiterkarte 2 eine metallische Platte, insbesondere eine Kupferschicht, auf. Diese metallische Platte ist insbesondere eine Masse-Lage. Die metallische Platte kann die durch Verlustleistung entstehende Wärme in Richtung einer darunter liegenden Kühlplatte abführen.

## Patentansprüche

1. Richtkoppler (1),
- der zumindest teilweise in einer insbesondere mehrlagigen Leiterkarte (2) des Richtkopplers (1) ausgebildet ist, mit
- einer Hauptleitung (3) zur Übertragung einer Leistung und
- zwei Nebenleitungen (6, 7), die jeweils in einem Kopplungsbereich mit einem Kopplungsabschnitt (4, 5) parallel und beabstandet zur Hauptleitung (3) angeordnet sind, wobei
- im Kopplungsbereich die Hauptleitung (3) und die zwei Nebenleitungen (6, 7) im Inneren der Leiterkarte (2) angeordnet sind, wobei
- an den Nebenleitungen (6, 7) m erste Zusatzkoppelleitungen (12 - 15), m ≥ 1, vorgesehen sind, die jeweils einen Kopplungsabschnitt (8 - 11) aufweisen, der parallel und beabstandet zum Kopplungsabschnitt (4, 5) der jeweiligen Nebenleitung (6, 7) verläuft, wobei
- die ersten Zusatzkoppelleitungen (12 - 15) einen Anschluss (16 - 19) aufweisen, der an der Außenseite der Leiterkarte (2) angeordnet ist zur Verbindung mit Masse oder einer externen Beschaltung, so dass durch die Verbindung eines oder mehrerer der Anschlüsse (16 - 19) der ersten Zusatzkoppelleitungen mit Masse die Kopplung des Richtkopplers (1) eingestellt werden kann bzw. Fertigungstoleranzen korrigiert werden können.

2. Richtkoppler nach Anspruch 1, **dadurch gekennzeichnet, dass** der Kopplungsabschnitt (8 - 11) der ersten Zusatzkoppelleitungen (12 - 15) kürzer ist als der Kopplungsabschnitt (4, 5) zumindest einer der Nebenleitungen (6, 7).

3. Richtkoppler nach einem der vorhergehenden Ansprüche, **dadurch gekennzeichnet, dass** in Längsrichtung des Kopplungsabschnitts (4, 5) zumindest einer der Nebenleitungen (6, 7) mehrere Kopplungsabschnitte (8 - 11) der ersten Zusatzkoppelleitungen (12 - 15) vorgesehen sind.

4. Richtkoppler nach einem der vorhergehenden Ansprüche, **dadurch gekennzeichnet, dass** die Kopplungsabschnitte (8 - 11) der ersten Zusatzkoppelleitungen (12 - 15) einen Abstand < 2 mm, insbesondere < 1 mm zum Kopplungsabschnitt (4, 5) zumindest einer der Nebenleitungen (6, 7) aufweisen.

5. Richtkoppler nach einem der vorhergehenden Ansprüche, **dadurch gekennzeichnet, dass** die Kopplungsabschnitte (8 - 11) der ersten Zusatzkoppelleitungen (12 - 15) auf einer der Hauptleitung (3) abgewandten Seite des Kopplungsabschnitts (4, 5) zumindest einer der Nebenleitungen (6, 7) angeordnet sind.

6. Richtkoppler nach einem der vorhergehenden Ansprüche, **dadurch gekennzeichnet, dass** die Kopplungsabschnitte (8 - 11) der ersten Zusatzkoppelleitung (12 - 15) einen geringeren Abstand zum Kopplungsabschnitt (4, 5) dieser Nebenleitung (6, 7) aufweisen als der Kopplungsabschnitt (4, 5) zumindest einer der Nebenleitungen (6, 7) zur Hauptleitung (3).

7. Richtkoppler nach einem der vorhergehenden Ansprüche, **dadurch gekennzeichnet, dass** n zweite Zusatzkoppelleitungen (24 - 27), n ≥ 1, vorgesehen sind, die einen Kopplungsabschnitt (20 - 23) aufweisen, der parallel und beabstandet zur Hauptleitung (3) verläuft und die elektrisch parallel zur zumindest einer der Nebenleitungen (6, 7) schaltbar oder geschaltet sind.

8. Richtkoppler nach Anspruch 7, **dadurch gekennzeichnet, dass** die Kopplungsabschnitte (20 - 23) der zweiten Zusatzkoppelleitungen (24 - 27) außerhalb des Kopplungsbereichs angeordnet sind.

9. Richtkoppler nach einem der vorhergehenden Ansprüche 7 oder 8, **dadurch gekennzeichnet, dass** die Kopplungsabschnitte (20 - 23) der zweiten Zusatzkoppelleitungen (24 - 27) in Längsrichtung des Kopplungsabschnitts (4, 5) zumindest einer der Nebenleitungen (6, 7) gesehen vor und/oder hinter dem Kopplungsabschnitt (4, 5) der Nebenleitung (6, 7) angeordnet sind.

10. Richtkoppler nach einem der vorhergehenden Ansprüche 7 bis 9, **dadurch gekennzeichnet, dass** die Kopplungsabschnitte (20 - 23) der zweiten Zusatzkoppelleitungen (24 - 27) kürzer sind als der Kopplungsabschnitt (4, 5) zumindest einer der Nebenleitungen (6, 7).

11. Richtkoppler nach einem der vorhergehenden Ansprüche, **dadurch gekennzeichnet, dass** die Kopplungsabschnitte (8 - 11) der ersten Zusatzkoppelleitungen (12 - 15) in derselben Lage angeordnet sind.

12. Richtkoppler nach einem der vorhergehenden Ansprüche, **dadurch gekennzeichnet, dass** zumindest eine der Nebenleitungen (6, 7) und die Zusatzkoppelleitungen (12 - 15, 24 - 27) als Leiterbahnen ausgebildet sind, wobei die Kopplungsabschnitte (8 - 11, 20 - 23) der Zusatzkoppelleitungen (12 - 15, 24 - 27) schmaler sind als der Kopplungsabschnitt (4, 5) dieser Nebenleitung (6, 7).

13. Richtkoppler nach einem der vorhergehenden Ansprüche, **dadurch gekennzeichnet, dass** die Kopplungsabschnitte (8 - 11, 20 - 23) der Zusatzkoppelleitungen (12 - 15, 24 - 27) in einer anderen Lage angeordnet sind als der Kopplungsabschnitt (4, 5) zumindest einer der Nebenleitungen (6, 7).

14. Richtkoppler nach einem der vorhergehenden Ansprüche, **dadurch gekennzeichnet, dass** der Richtkoppler (1) bezüglich einer Mittenebene (30) der Hauptleitung (3) symmetrisch aufgebaut ist.

15. Verfahren zum Abstimmen eines Richtkopplers (1), nach einem der vorhergehenden Ansprüche, wobei
zum Abstimmen ein oder mehrere Anschlüsse (16 - 19) der ersten Zusatzkoppelleitungen (12 - 15) mit Masse verbunden werden, und insbesondere n, n ≥ 1, zweiten Zusatzkoppelleitungen (24 - 27) elektrisch parallel zu der zumindest einen Nebenleitung (6, 7) geschaltet werden, wobei der oder die mehreren Anschlüsse (16 - 19) der ersten Zusatzkoppelleitungen (12 - 15), und insbesondere n, zur Einstellung der Kopplung geeignet gewählt werden, so dass die Änderung der Kopplung aufgrund von Fertigungstoleranzen ausgeglichen wird.

## Claims

1. A directional coupler (1),
- which is at least partly formed in an in particular multilayer printed circuit board (2) of the directional coupler (1), having
- a main line (3) for transmitting an output and
- two secondary lines (6, 7), which are each arranged in a coupling region with a coupling portion (4, 5) in parallel with and at a distance from the main line (3), wherein
- in the coupling region, the main line (3) and the two secondary lines (6, 7) are arranged in the interior of the printed circuit board (2), wherein
- on the secondary lines (6, 7) m first additional coupling lines (12-15), m ≥ 1, are provided, each of which has a coupling portion (8-11) which extends in parallel with and at a distance from the coupling portion (4, 5) of the respective secondary line (6, 7), wherein
- the first additional coupling lines (12-15) have a terminal (16-19) which is arranged on the outside of the printed circuit board (2) for connecting to earth or an external circuit so that, by connecting one or more of the terminals (16-19) of the first additional coupling lines to earth, the coupling of the directional coupler (1) can be adjusted or manufacturing tolerances can be corrected.

2. The directional coupler according to claim 1, **characterised in that** the coupling portion (8-11) of the first additional coupling lines (12-15) is shorter than the coupling portion (4, 5) of at least one of the secondary lines (6, 7).

3. The directional coupler according to any one of the preceding claims, **characterised in that** a plurality of coupling portions (8-11) of the first additional coupling lines (12-15) are provided in the longitudinal direction of the coupling portion (4, 5) of at least one of the secondary lines (6, 7).

4. The directional coupler according to any one of the preceding claims, **characterised in that** the coupling portions (8-11) of the first additional coupling lines (12-15) are at a distance of <2 mm, in particular <1 mm, from the coupling portion (4, 5) of at least one of the secondary lines (6, 7).

5. The directional coupler according to any one of the preceding claims, **characterised in that** the coupling portions (8-11) of the first additional coupling lines (12-15) are arranged on a side of the coupling portion (4, 5) of at least one of the secondary lines (6, 7), said side facing away from the main line (3).

6. The directional coupler according to any one of the preceding claims, **characterised in that** the coupling portions (8-11) of the first additional coupling line (12-15) are at a smaller distance from the coupling portion (4, 5) of said secondary line (6, 7) than the coupling portion (4, 5) of at least one of the secondary lines (6, 7) is at from the main line (3).

7. The directional coupler according to any one of the preceding claims, **characterised in that** n second additional coupling lines (24-27), n ≥ 1, are provided which have a coupling portion (20-23), which extends in parallel with and at a distance from the main line (3), and which can be or are wired electrically in parallel with at least one of the secondary lines (6, 7).

8. The directional coupler according to claim 7, **characterised in that** the coupling portions (20-23) of the second additional coupling lines (24-27) are arranged outside the coupling region.

9. The directional coupler according to any one of the preceding claims 7 or 8, **characterised in that** the coupling portions (20-23) of the second additional coupling lines (24-27), seen in the longitudinal direction of the coupling portion (4, 5) of at least one of the secondary lines (6, 7), are arranged upstream and/or downstream of the coupling portion (4, 5) of the secondary line (6, 7).

10. The directional coupler according to any one of the preceding claims 7 to 9, **characterised in that** the coupling portions (20-23) of the second additional coupling lines (24-27) are shorter than the coupling portion (4, 5) of at least one of the secondary lines (6, 7).

11. The directional coupler according to one of the preceding claims, **characterised in that** the coupling portions (8-11) of the first additional coupling lines (12-15) are arranged in the same layer.

12. The directional coupler according to any one of the preceding claims, **characterised in that** at least one of the secondary lines (6, 7) and the additional coupling lines (12-15, 24-27) are designed as conductor tracks, the coupling portions (8-11, 20-23) of the additional coupling lines (12-15, 24-27) being narrower than the coupling portion (4, 5) of said secondary line (6, 7).

13. The directional coupler according to one of the preceding claims, **characterised in that** the coupling portions (8-11, 20-23) of the additional coupling lines (12-15, 24-27) are arranged in a different layer from the coupling portion (4, 5) of at least one of the secondary lines (6, 7).

14. The directional coupler according to one of the preceding claims, **characterised in that** the directional coupler (1) is constructed symmetrically with respect to a central plane (30) of the main line (3).

15. A method for adjusting a directional coupler (1) according to any one of the preceding claims, wherein, for adjusting, one or more connections (16-19) of the first additional coupling lines (12-15) are connected to earth, and in particular n, n ≥ 1, second additional coupling lines (24-27) are wired electrically in parallel with the at least one secondary line (6, 7), wherein the one or more terminals (16-19) of the first additional coupling lines (12-15), and in particular n, are suitably selected for adjusting the coupling such that the change in coupling due to manufacturing tolerances is compensated for.

## Revendications

1. Coupleur directif (1),
- constitué au moins en partie par une carte de circuit imprimé (2) en particulier multicouche, du coupleur directif (1), comprenant
- un conducteur principal (3) pour la transmission d'une puissance et
- deux conducteurs secondaires (6, 7), dont une partie de couplage (4, 5) est respectivement agencée parallèlement et à distance du conducteur principal (3) dans une zone de couplage, dans lequel
- le conducteur principal (3) et les deux conducteurs secondaires (6, 7) sont agencés à l'intérieur de la carte de circuit imprimé (2) dans la zone de couplage, dans lequel
- au niveau des conducteurs secondaires (6, 7), m premiers conducteurs de couplage supplémentaires (12 - 15), m ≥ 1, sont prévus, chacun ayant une partie de couplage (8 - 11) qui s'étend parallèlement et à distance de la partie de couplage (4, 5) du conducteur secondaire respectif (6, 7), dans lequel
- les premiers conducteurs de couplage supplémentaires (12 - 15) présentent une borne (16 - 19) agencée sur le côté extérieur de la carte de circuit imprimé (2) pour une connexion à la terre ou à un circuit externe, de sorte que, par la connexion d'une ou plusieurs des bornes (16 - 19) des premiers conducteurs de couplage supplémentaires avec la terre, le couplage du coupleur directif (1) peut être réglé ou les tolérances de fabrication peuvent être corrigées.

2. Coupleur directif selon la revendication 1, **caractérisé en ce que** la partie de couplage (8 - 11) des premiers conducteurs de couplage supplémentaires (12 - 15) est plus courte que la partie de couplage (4, 5) d'au moins un des conducteurs secondaires (6, 7).

3. Coupleur directif selon l'une quelconque des revendications précédentes, **caractérisé en ce que** plusieurs parties de couplage (8 - 11) des premiers conducteurs de couplage supplémentaires (12 - 15) sont prévues dans la direction longitudinale de la partie de couplage (4, 5) d'au moins un des conducteurs secondaires (6, 7).

4. Coupleur directif selon l'une quelconque des revendications précédentes, **caractérisé en ce que** les parties de couplage (8 - 11) des premiers conducteurs de couplage supplémentaires (12 - 15) présentent une distance <2 mm, en particulier <1 mm à la partie de couplage (4, 5) d'au moins un des conducteurs secondaires (6, 7).

5. Coupleur directif selon l'une quelconque des revendications précédentes, **caractérisé en ce que** les parties de couplage (8 - 11) des premiers conducteurs de couplage supplémentaires (12 - 15) sont agencées sur un côté de la partie de couplage (4, 5) d'au moins un des conducteurs secondaires (6, 7) tourné à l'opposé du conducteur principal (3).

6. Coupleur directif selon l'une quelconque des revendications précédentes, **caractérisé en ce que** les parties de couplage (8 - 11) du premier conducteur de couplage supplémentaire (12 - 15) présentent une distance plus petite à la partie de couplage (4, 5) de ce conducteur secondaire (6, 7) que la partie de couplage (4, 5) d'au moins un des conducteurs secondaires (6, 7) au conducteur principal (3).

7. Coupleur directif selon l'une quelconque des revendications précédentes, **caractérisé en ce que** n seconds conducteurs de couplage supplémentaires (24 - 27), n ≥ 1, sont prévus, qui présentent une partie de couplage (20 - 23) qui s'étend parallèlement et à distance du conducteur principal (3) et qui peuvent être commutés ou connectés électriquement en parallèle avec au moins un des conducteurs secondaires (6, 7).

8. Coupleur directif selon la revendication 7, **caractérisé en ce que** les parties de couplage (20 - 23) des seconds conducteurs de couplage supplémentaires (24 - 27) sont agencées à l'extérieur de la zone de couplage.

9. Coupleur directif selon l'une quelconque des revendications 7 ou 8 précédentes, **caractérisé en ce que** les parties de couplage (20 - 23) des seconds conducteurs de couplage supplémentaires (24 - 27) vues dans la direction longitudinale de la partie de couplage (4, 5) d'au moins un des conducteurs secondaires (6, 7) sont agencées devant et/ou derrière la partie de couplage (4, 5) du conducteur secondaire (6, 7).

10. Coupleur directif selon l'une quelconque des revendications précédentes 7 à 9, **caractérisé en ce que** les parties de couplage (20 - 23) des seconds conducteurs de couplage supplémentaires (24 - 27) sont plus courtes que la partie de couplage (4, 5) d'au moins un des conducteurs secondaires (6, 7).

11. Coupleur directif selon l'une quelconque des revendications précédentes, **caractérisé en ce que** les parties de couplage (8 - 11) des premiers conducteurs de couplage supplémentaires (12 - 15) sont agencées dans la même couche.

12. Coupleur directif selon l'une quelconque des revendications précédentes, **caractérisé en ce qu'**au moins un des conducteurs secondaires (6, 7) et des conducteurs de couplage supplémentaires (12 - 15, 24 - 27) sont conçus comme des pistes conductrices, dans lequel les parties de couplage (8 - 11, 20 - 23) des conducteurs de couplage supplémentaires (12 - 15, 24 - 27) sont plus étroites que la partie de couplage (4, 5) de ce conducteur secondaire (6, 7).

13. Coupleur directif selon l'une quelconque des revendications précédentes, **caractérisé en ce que** les parties de couplage (8-11, 20 - 23) des conducteurs de couplage supplémentaires (12 - 15, 24 - 27) sont agencées dans une couche différente de la partie de couplage (4, 5) d'au moins un des conducteurs secondaires (6, 7).

14. Coupleur directif selon l'une quelconque des revendications précédentes, **caractérisé en ce que** le coupleur directif (1) est construit symétriquement par rapport à un plan central (30) du conducteur principal (3).

15. Procédé pour accorder un coupleur directif (1) selon l'une quelconque des revendications précédentes, dans lequel pour l'accord, une ou plusieurs bornes (16 - 19) des premiers conducteurs de couplage supplémentaires (12 - 15) sont connectées à la terre et, en particulier n, n ≥ 1, seconds conducteurs de couplage supplémentaires (24 - 27) sont connectés électriquement en parallèle à l'au moins un conducteur secondaire (6, 7), dans lequel la ou les plusieurs bornes (16 - 19) des premiers conducteurs de couplage supplémentaires (12 - 15), et en particulier n, sont choisies pour le réglage du couplage de manière appropriée afin que le changement du couplage soit compensé en raison des tolérances de fabrication.
